# EUROPEAN PATENT APPLICATION

(11) **EP 4 300 552 A1**
(43) Date of publication of application: **03.01.2024**
(21) Application number: 22181793.5
(22) Date of filing: 29.06.2022
(51) Int. Cl.: H01L 21/56, H01L 23/495, H01L 23/31

(54) **A METHOD OF MANUFACTURING SEMICONDUCTOR PACKAGE ASSEMBLY AND A SEMICONDUCTOR PACKAGE ASSEMBLY MANUFACTURED USING THIS METHOD**

(71) Applicant: Nexperia B.V., 6534 AB Nijmegen (NL)
(72) Inventor: Lam, Hiu Hay Nichole, Hong Kong (HK); Yip, Shu-ming, Hong Kong (HK); Leung, Chi Ho, Hong Kong (HK); Yeung, Shun Tik, Hong Kong (HK)
(74) Representative: Pjanovic, Ilija

(57) **Abstract**

The present disclosure relates to manufacturing techniques for manufacturing multiple semiconductor package assemblies on a lead frame as well as a semiconductor package assembly manufactured using this method. The method aims to reduce the distances or intermediate spacings between singulated semiconductor packages on a lead frame to a width equal to the width of a cutting tool which width is significantly smaller than the distance required in any known modelling encapsulation technique. Therefore the method according to the disclosure allows to position more semiconductor packages on a lead frame on one process step. Accordingly, as the number of semiconductor packages per lead frame surface is increased, more semiconductor packages can manufactured and singulated in one process step, which reduces costs and processing time.

## Description

### TECHNICAL FIELD

The present disclosure relates to manufacturing techniques for manufacturing multiple semiconductor package assemblies on a lead frame as well as a semiconductor package assembly manufactured using this method.

### BACKGROUND OF THE DISCLOSURE

When manufacturing a semiconductor package assembly, semiconductor components forming the semiconductor package are mounted to a lead frame and one or more bond clips are electronically connected with either the semiconductor die or with the lead frame. For finalizing the semiconductor package assembly, the semiconductor package is encapsulated using a dielectric material like plastic resin, thus immobilizing and protecting the fragile solder connection between the bond clips and the semiconductor die and the lead frame and allowing a proper handling and processing of the semiconductor package assembly in semiconductor applications.

The encapsulation step requires that a space is left between each semiconductor package assembly, which space big enough to fit a mould cavity wall. Mould cavity walls must be strong enough to hold the dielectric material processing pressure that is required in the encaustic process using proper techniques. The most common encapsulation technique is injection moulding of a thermoplastic polymer. This process requires high pressures and temperature so the cavity walls are thick. Therefore the multiple semiconductor package assemblies must be spread out significantly across the lead frame surface. This reduces the possible number of semiconductor package assemblies encapsulated in one encapsulation process per lead frame as the dimensions of the encapsulation mould (of any kind) is limited.

Accordingly, it is a goal of the present disclosure to provide an improved method of manufacturing semiconductor package assemblies as well as a semiconductor package assembly manufactured using this method, in which the spaces between the individual semiconductor package assemblies on one lead frame are significantly reduced.

### SUMMARY OF THE DISCLOSURE

In a particular example of the method according to the disclosure, the method comprises the steps: a) providing a metallic lead frame fabricated from a metal sheet having a first longitudinal dimension and a second longitudinal dimension, the lead frame composed of a plurality of die paddles forming at least one die paddle column oriented in the first longitudinal dimension and a plurality of terminals forming at least one terminal column oriented in the first longitudinal dimension. In a further step b) a plurality of semiconductor die components are attached to each of the plurality of die paddles. In a next step c) a connection between the semiconductor die components with the plurality of terminals is performed. Step c) is followed by step d) which comprises step of encapsulating the plurality of semiconductor die components by covering at least one pair of the at least one die paddle column and the at least one terminal column with the terminal parts at least partly exposed with a dielectric material.

Thus step d) thereby forms a single encapsulation block for each pair consisting of the at least one die paddle column and the at least one terminal column. In a next step e) trimming the exposed terminal parts is performed, followed by step f) of singulating semiconductor packages by cutting the at least one single encapsulation block in the second longitudinal direction into at least two single semiconductor packages. When performing the singulating step f) the cutting line lays at least between the at least two semiconductor die components. Alternatively, it is noted that steps e) and f) can be interchanged in the manufacturing sequence, meaning that in the alternative sequence the singulating step f) is performed directly after performing step d), and that step f) is followed by the trimming step e).

The resulting method as outlined above reduces the distances or intermediate spacings between the singulated semiconductor packages on the lead frame to a width equal to the width of a cutting tool using for step f) which width is significantly smaller than the distance required in any known modelling encapsulation technique. Therefore the method according to the disclosure allows to position more semiconductor packages on a lead frame on one process step. Accordingly, as the number of semiconductor packages per lead frame surface is increased, more semiconductor packages can manufactured and singulated in one process step, which reduces costs and processing time.

In particular, with the method according to the disclosure, lead frames can be processed with a higher density of semiconductor packages which will result in an increased throughput.

In a detail of the method according to the disclosure, the step b) further may comprise the step of attaching the semiconductor die components to the die paddles by means of adhesive bonding, eutectic bonding or solder bonding. Due to the higher number of semiconductor packages per lead frame surface area, bonding distances can be shortened, increasing the indexing speed.

In a further example of the disclosure any one of the steps a) to f) are preceded by a surface treatment step, a coating step, a plating step or a galvanizing step.

In a preferred example, step e) is preceded with a step g) of plating the exposed terminal parts with a material suitable for solder mounting a semiconductor package.

In yet another example, the step g) of plating the exposed terminal parts comprises plating with a tin alloy suitable for solder mounting a semiconductor package.

In another beneficial example according to the disclosure the manufacturing method allows for at least two single semiconductor packages being separated by a distance or spacing of less than 3 mm, preferably less than 1 mm seen in second longitudinal direction. Preferably, the spacing between the at least two single semiconductor packages exhibits a range of 0.03-0.35 mm, in particular a range of 0.12-0.18 mm, in particular the spacing is 0.15 mm.

Next, another beneficial example according to the disclosure relates to the step d) being performed using injection moulding of a thermoplastic polymer. Alternatively, the step d) may be performed using polymer resin casting, wherein the resin is a photo-, a chemo-, or a thermo-curable resin. In another example according to the disclosure the step d) may be performed using a ceramic material.

For singulating the individual semiconductor packages the step f) may comprise the technique of laser cutting or mechanic sawing.

The disclosure also pertains to a semiconductor package manufactured using the disclosed method, with at least one side wall of the semiconductor package being orientated parallel to the second longitudinal dimension of the metallic lead frame having substantially a flat surface which flat surface is positioned perpendicular to a bottom side or a top side of the semiconductor package.

### BRIEF DESCRIPTION OF THE DRAWINGS

The disclosure will now be discussed with reference to the drawings, which show in:
Figure 1a-1g the various steps of an example of a method according to the disclosure;
Figure 2a an examples of a semiconductor package (assembly) according to the prior art;
Figure 2b an example of a semiconductor package (assembly) according to the disclosure;
Figure 3a-3b another example of a semiconductor package (assembly) according to the prior art and the disclosure;
Figure 4a-4b another example of a semiconductor package (assembly) according to the prior art and the disclosure;
Figure 5a-5b another example of a semiconductor package (assembly) according to the prior art and the disclosure;
Figure 6 an example of a schematic lead frame design according to the disclosure.

### DETAILED DESCRIPTION OF THE DISCLOSURE

For a proper understanding of the disclosure, in the detailed description below corresponding elements or parts of the disclosure will be denoted with identical reference numerals in the drawings.

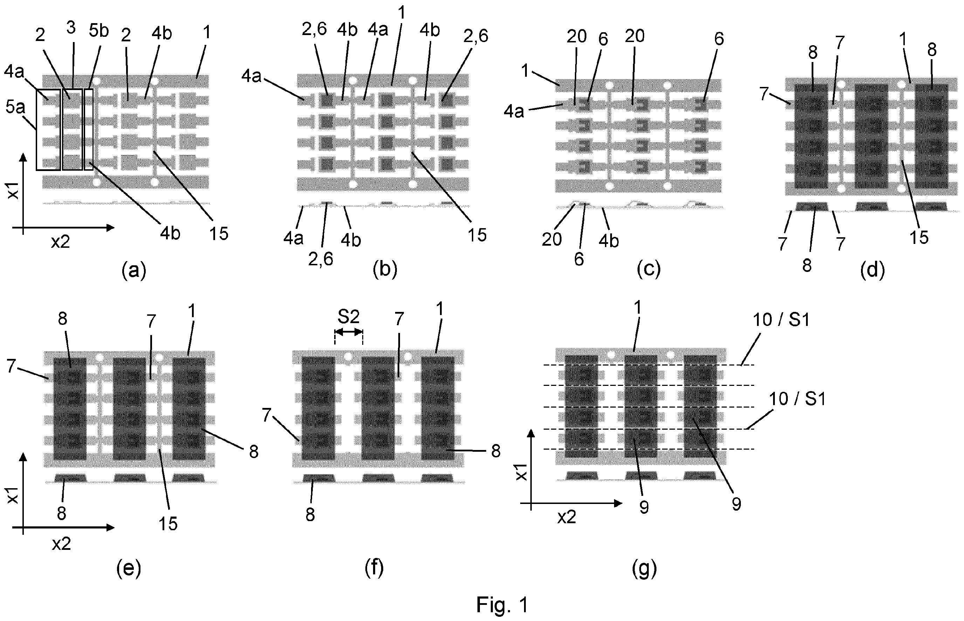

Figure 1 depicts in sub figures a) to g) an example of the method according to the disclosure, the various steps being denoted with Figures 1a-1f. In a first step a) a metallic lead frame 1 which fabricated from a metal sheet is provided, the metallic lead frame 1 being suited for having multiple semiconductor die components mounted thereon. The metallic lead frame 1 can be chosen from any electrically conductive metal material but preferably copper is used for the lead frame. The lead frame 1 has a planar structure with a first longitudinal dimension x1 and a second longitudinal dimension x2.

In this particular example, the first longitudinal dimension x1 and the second longitudinal dimension x2 are oriented perpendicular to each other, in an orthogonal axis orientation. However, it can be envisaged that both longitudinal dimensions x1 and x2 can have a non-perpendicular orientation with respect to each other, with an acute angle being smaller than 90°.

The lead frame 1 comprise a plurality die paddles 2, which are oriented in a die paddle column 3 extending in or parallel to the first longitudinal dimension x1. In this particular example, the lead frame 1 comprises three die paddle columns 3 which seen in the second longitudinal dimension x2 are oriented parallel to each other. The die paddle columns 3 are oriented in the first longitudinal dimension x1, which first orientation x1 also can be referred as vertically or a vertical orientation.

The lead frame 1 has plurality of terminals 4 (4a-4b), in this example, each die paddle 2 has two terminals 4a-4b provided forming a terminal pair. Of each terminal pair, one terminal 4a of the pair is connected with the die paddle 2 and the other terminal 4b is separately mounted in the lead frame 1, being not connected with the respective die paddle 2.

Furthermore, in step a) the terminals 4a-4b of each die paddle 2 each form a terminal column 5a-5b oriented in the first longitudinal dimension x1 (vertically). Some parts of terminals 4a-4b and die paddles 2 have additional frame connections 15 with the lead frame 1 and to each other for providing a mechanical straight and stiffness during manufacturing the semiconductor package assemblies. This additional frame connections 15 are known in the prior art as construction strengthening elements and will be removed during the further steps of manufacturing.

Step b) of the method according to the disclosure pertains attaching semiconductor die components 6 to each of the die paddles 2.

Step c) of the method according to the disclosure pertains to electrically connecting the semiconductor die components 6 with the plurality of terminals 4a using an electric connection 20, such as a bond clip 20. The semiconductor die components 6 are connected to the terminal 4a, in particular to the terminals 4a that are separated from the die paddles 2. In this example one electric connection (bond clip) 20 is made but there are other configurations of connection possible including connecting each semiconductor die component 6 to more than one terminals 4a-4b.

Following step c), step d) of the method according to the disclosure pertains to encapsulating the plurality of semiconductor die components 6 by covering pairs of the one die paddle column 3 and the one terminal column 4a and/or 4b with a dielectric material 8. According to this method whole terminal columns 4a and/or 4b are being covered with dielectric material 8, but parts of the terminals 4a-4b, which terminal parts are denoted with reference numeral 7, are at least partly exposed.

The exposed parts 7 of terminals 4a-4b which are not covered with the dielectric material 8 allow the semiconductor package 9 to be - during later applications - stable soldered to a printed circuit board (PCB), not shown. After the encapsulating step d), the dielectric material 8 forms a single encapsulation block with an elongated orientation parallel to the first longitudinal dimension x1. Each encapsulating block 8 consist of the at least one die paddle column 3 and the at least one terminal column 4a-4b, thus encapsulating multiple semiconductor die components 6. Note, that of each terminal column 4a-4b, the respective terminals 4a and 4b have exposed terminal parts 7 extending from the encapsulating block / dielectric material 8.

As shown in Figure 1d, the several encapsulating blocks 8 are separated from each other in the second longitudinal dimension x2 by means of a spacing S2, this separation is needed for trimming the lead frame 1.

The next step is shown in Figure 1f and comprises trimming the exposed terminal parts 7 by removing the connections 15. Herewith, a semiconductor package terminal 7 is formed, which - during later handling applications - is suitable for mounting to an electronic circuit e.g. through soldering. The exposed semiconductor package terminals 7 may be further undergo a shaping step after the trimming step (Figure 1f) in order to obtain a standardized dimension, which might be different per semiconductor package type. In this step some or all additional connections 15 are trimmed and/or removed.

In the final step, as shown in Figure 1g, of the method according to the disclosure the several semiconductor packages 9 in each encapsulating blocks 8 are singulated by cutting each single encapsulation block 8 several times in the second longitudinal direction x2. The pathway of the cutting tool is denoted as the cutting line 10, which is parallel to the second longitudinal direction x2, and which pathway or cutting line 10 lays at least between the at least two semiconductor die components 6 of each die paddle column 3. The cutting process is to be performed between the die paddles 2, but the cutting process may also be performed through the die paddles 2.

Alternatively, it is noted that trimming step of Figure 1f and the singulating step of Figure 1g can be interchanged in the manufacturing sequence, meaning that in the alternative sequence the singulating step in Figure 1g is performed directly after performing the step d) of Figure 1d, and that the singulating step of Figure 1g is followed by the trimming step of Figure 1f.

With the method according to the disclosure, the spacing S1 between the singulated, encapsulated semiconductor packages assemblies is much more reduced (is much smaller) compared the spacing in other know methods. The spacing S1 between the singulated, encapsulated semiconductor packages 9 is only limited by the width 10 of cutting tool or cutting process requirements. The spacing is not limited by the method itself or by the material used for the encapsulating process, and therefore the spacing S1 can become significantly smaller as the width of the cutting tools used can be up to 0.03 mm thin.

In conformity with the method according to the disclosure in the step c) the semiconductor die components 6 are attached to the die paddles 2 by means of solder bonding using a soldering material. In another example the semiconductor die component 6 can be attached to the die paddle 2 by means of adhesive bonding e.g. glue or eutectic bonding.

Furthermore the method according to the disclosure also includes surface treatment steps. Surface treatments changes the properties of the surface parts of the several elements making them more or less susceptible to chemicals and atmospheres thus making them more or less adhesive e.g. through brushing, galvanizing, or etching, or making the surfaces more or less suitable for soldering e.g. through plating. Some surface treatments e.g. coating cause elements of the semiconductor package to be more resistant to atmospheric conditions. Such surface treatments may be performed on any of the steps of the method according to the disclosure, to all elements or to some elements e.g. only applied to the terminals 4a-4b.

In addition, as detailed in Figure 1e, trimming step of Figure 1f is preceded with a plating step, wherein the exposed terminal parts 7 are plated with a material suitable for solder mounting a semiconductor package e.g. tin and tin alloys, gold, silver and silver alloys and others.

According to the disclosure, the spaces S1 between the singulated, encapsulated semiconductor packages 9 are limited by the width 10 of the cutting tool being implemented. Therefore it is possible to have two single semiconductor packages 9 to be separated by less than 3 mm, preferably by less than 1 mm seen in the second longitudinal direction x2. Preferably they are separated by a range of 0.03-0.35 mm, in particular by a range of 0.12-0.18 mm.

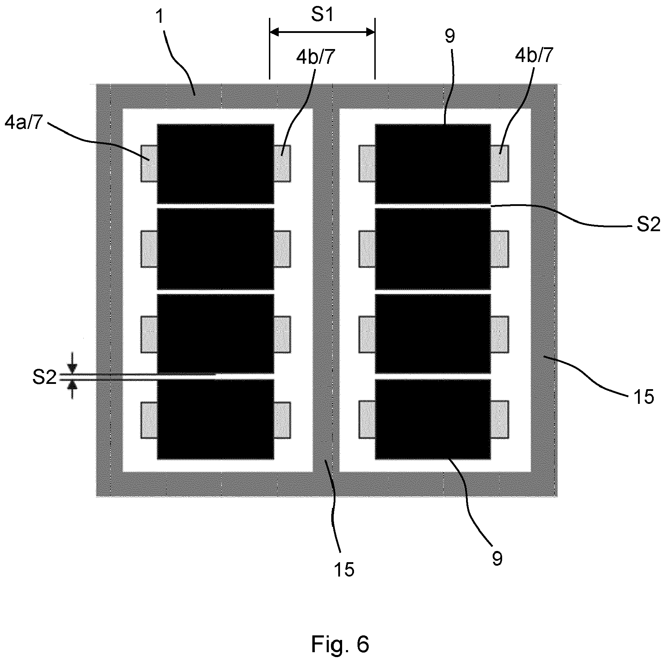

In the preferred embodiment as shown in Figure 6 single or individual semiconductor packages 9 are separated by a spacing S1 of 0.15 mm which can the width of a saw blade 10 used for singulation step of Figure 1f. In other preferred embodiments this width S1 may be up to 0.03 mm, when a laser beam is used in the singulating step of Figure 1f as the cutting tool or cutting technique. Preferred cutting techniques are indeed laser cutting or mechanic sawing, preferably rotating blade sawing. However any technique suitable for cutting the encapsulation dielectric material 8 can be implemented.

The dielectric material 8 is preferably an electrically insulating material suitable for protecting the semiconductor die components 6 from short circuits and from atmospheric exposure. Such materials 8 are well known in the state of the art and suitable materials may be selected from polymers resins for casting. The resin 8 may be a photo-, a chemo-, or a thermo-curable resin when the encapsulation step is performed by mold casting. In other embodiments, the encapsulation step is performed using injection molding of a thermoplastic polymer e.g. Polypropylene, Polyamide, Polyacetal, Polycarbonate, Poly(methyl methacrylate) and such. Other dielectric materials 8 used may be ceramic materials or ceramic composite materials.

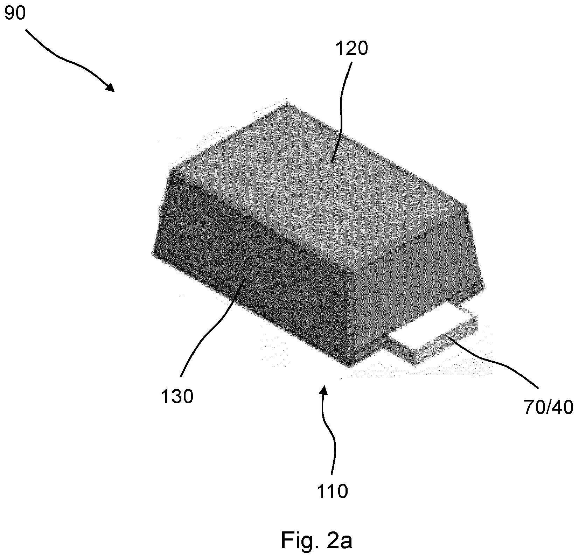

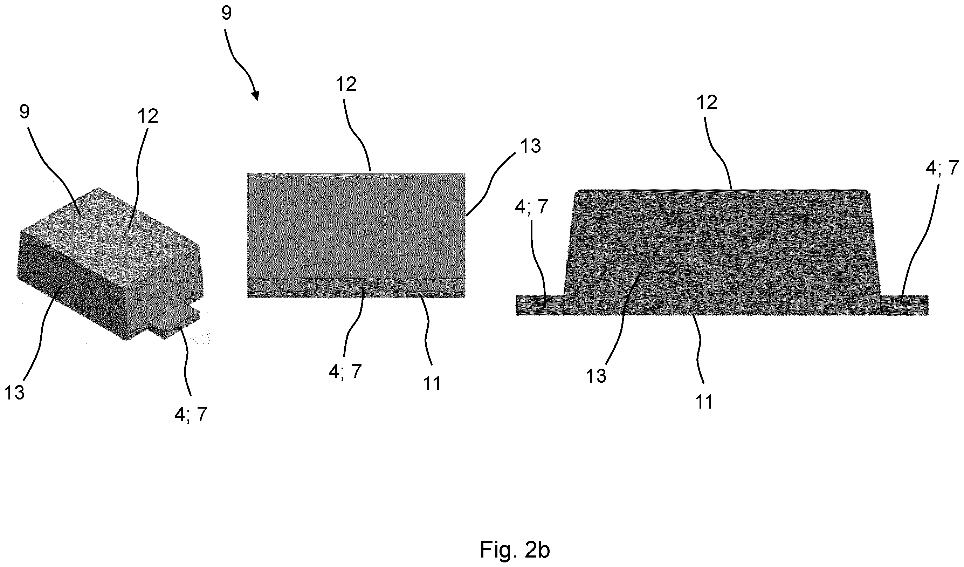

Referring to Figure 2b, the singulated semiconductor package 9 as manufactured using the method according to the disclosure, comprises at least one side wall 13 which is orientated parallel to the second longitudinal dimension x2. The side wall 13 has substantially flat surface which is perpendicular to a bottom side 11 or a top side 12 of the semiconductor package 9. The state of the art package 90 of Figure 2a is shown with exposed terminal parts 70 of the terminals 40 and with side walls 130 which are angled with respect to the bottom side 110 and/or the top side 120.

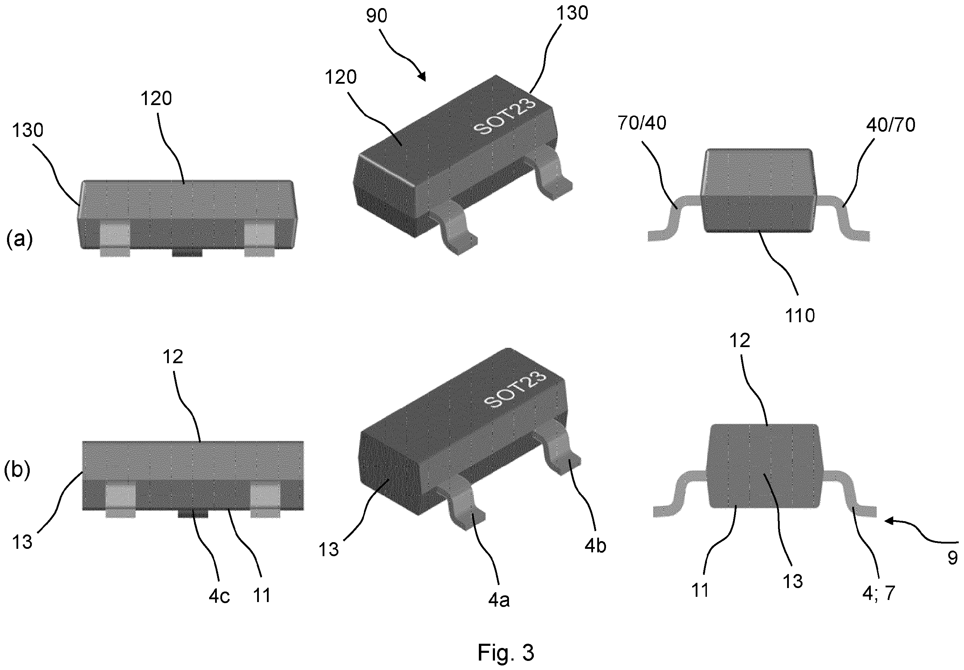

In the example as shown in Figure 3b, a single semiconductor package 9 according to the disclosure is shown having two terminals 4a-4b on one side and one terminal 4c on the opposite side. It has side walls 13 with a substantially flat surface which surface is perpendicular to the bottom side 11 and/or the top side 12 of the semiconductor package 9. Figure 3a shows a state of the art semiconductor package 90 with exposed terminal parts 70 of the terminals 40 and with angled side walls 130 which are angled with respect to the bottom side 110 and/or the top side 120, similar as in the state of the art example of Figure 2a.

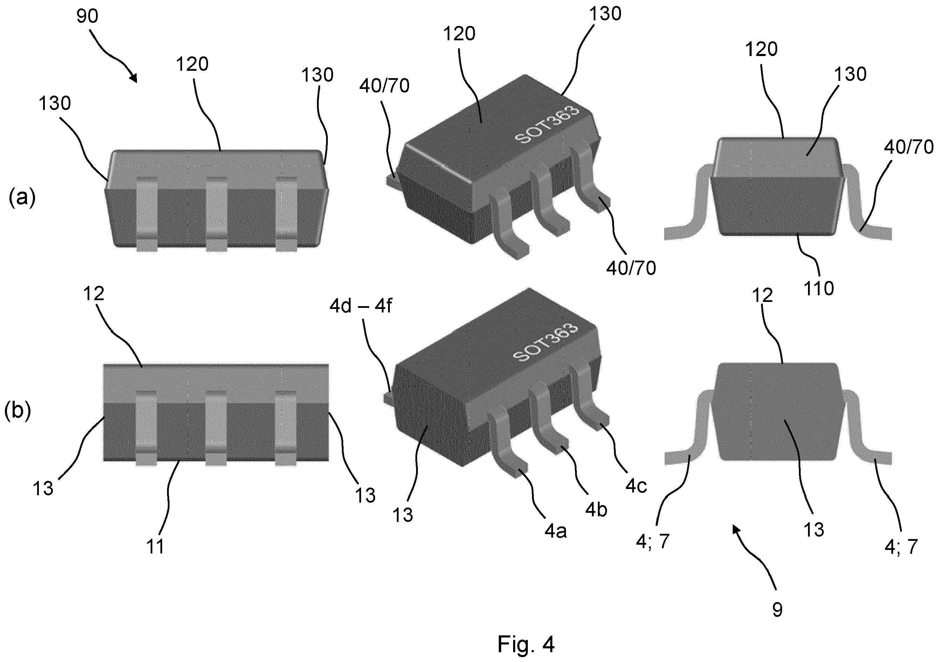

In Figure 4b, a standard SOT23 package 9 manufactured according the disclosure is shown. The side wall 13 has a flat orientation and is oriented perpendicular to both the bottom side 11 and the top side 12 of the semiconductor package 9, contrary to the state of the art package 90 as shown in Figure 4a with exposed terminal parts 70 of the terminals 40 and with angled side walls 130 which are angled with respect to the bottom side 110 and/or the top side 120, similar as the state of the art example of Figure 2a. In Figure 4b, the semiconductor package 9 has three terminals 4a-4c on each side of the package (six terminals 4a-4f in total), of which the exposed terminal parts 7 are cut and bended to a standardized shape in the step e) of the method according to the disclosure.

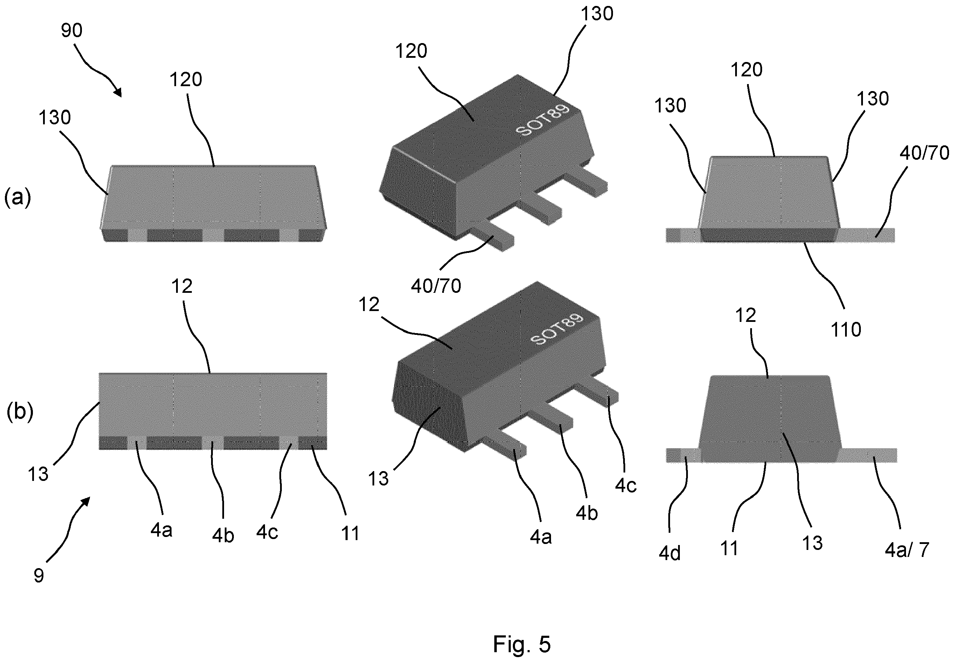

In Figure 5b another embodiment is shown, showing a SOT363 package according to the disclosure, also having three terminals 4a-4c on each side of the package (six terminals 4a-4f in total). Likewise, the side walls 13 have a flat surface and are oriented perpendicular to both the bottom side 11 and the top side 12 of the semiconductor package / SOT363. Similarly, the exposed terminal parts 7 were cut and bended to a standardized shape in the step e) of the method. The state of the art package 90 as shown in Figure 5a has angled side walls 130 which are angled with respect to the bottom side 110 and/or the top side 120, similar as the state of the art example of Figure 2a.

### LIST OF REFERENCE NUMERALS USED

- 1: metallic lead frame
- x1: first longitudinal dimension of lead frame 1
- x2: second longitudinal dimension of lead frame 1
- 2: die paddle
- 3: die paddle column
- 4 (4a-4f): terminals
- 5a-5b: terminal column
- 6: semiconductor die component
- 7: exposed terminal parts
- 8: dielectric material / encapsulating block
- 9: semiconductor package according to the disclosure
- 10: cutting line / width of cutting tool (cutting blade / cutting saw / laser beam)
- 11: bottom side
- 12: topside
- 13: side wall according to the disclosure
- 15: frame connection
- 20: electric connection / bond clip / bond wire
- S1: spacing seen in first longitudinal direction x1
- S2: spacing seen in second longitudinal direction x2
- 90: semiconductor package according to the state of the art
- 40: terminals of semiconductor package according to the state of the art
- 70: exposed terminal parts of semiconductor package according to the state of the art
- 110: bottom side of semiconductor package according to the state of the art
- 120: top side of semiconductor package according to the state of the art
- 130: side wall of semiconductor package according to the state of the art

## Claims

1. A method of manufacturing a semiconductor package comprising the steps:
a) providing a metallic lead frame (1) fabricated from a metal sheet having a first longitudinal dimension and a second longitudinal dimension the lead frame composed of a plurality of die paddles (2) forming at least one die paddle column (3) oriented in the first longitudinal dimension and a plurality of terminals (4) forming at least one terminal column (5) oriented in the first longitudinal dimension;
b) attaching a plurality of semiconductor die component (6) to each of the plurality of die paddles (2);
c) connecting the semiconductor die component (6) with the plurality of terminals;
d) encapsulating the plurality of semiconductor die component (6) by covering at least one pair of the at least one die paddle column (3) and the at least one terminal column (4) with the terminal parts (7) at least partly exposed with dielectric material, thereby forming a single encapsulation block (8) for each pair consisting of the at least one die paddle column (3) and the at least one terminal column (4);
e) trimming the exposed terminal parts (7);
f) singulating semiconductor packages by cutting the at least one single encapsulation block in the second longitudinal direction into at least two single semiconductor packages (9) wherein the cutting line (10) lays at least between the at least two semiconductor die component (6).

2. The method according to claim 1, wherein step c) comprises the step of attaching the semiconductor die component (6) to the die paddles (2) by means of adhesive bonding, eutectic bonding or solder bonding.

3. The method according to claim 1 or 2, wherein any one of steps a) to f) is preceded with a surface treatment, a coating, a plating or a galvanizing step.

4. The method according to any one or more of the claims 1 to 3, wherein step e) is preceded with the step g) of plating the exposed terminal parts(14) with a material suitable for solder mounting a semiconductor package.

5. The method according to claim 4, wherein the step of plating the exposed terminal parts comprises plating with a tin alloy suitable for solder mounting a semiconductor package.

6. The method according to any one or more of the claims 1 to 5, wherein at least two single semiconductor packages (9) are separated by less than 3 mm, preferably less than 1 mm seen in second longitudinal direction.

7. The method according to claim 6, wherein at least two single semiconductor packages (9) are separated by a range of 0.03-0.35 mm, in particular by a range of 0.12-0.18 mm, in particular 0.15 mm.

8. The method according to any one or more of the claims 1 to 7, wherein the step d is performed using injection molding of thermoplastic polymer.

9. The method according to any one or more of the claims 1 to 8, wherein the step d is performed using polymer resin casting and the resin is a photo-, a chemo-, or a thermo-curable resin.

10. The method according to any one or more of the claims 1 to 9, wherein the step d is performed using ceramic material.

11. The method according to any one or more of the claims 1 to 10, wherein the step f is performed by means of laser cutting or mechanic sawing, preferably rotating blade sawing.

12. A semiconductor package manufactured using the method according to any one or more of the method claims 1 to 11, wherein at least one side wall (13) of the semiconductor package orientated parallel to the second longitudinal dimension has substantially flat surface which is perpendicular to a bottom (11) or a top (12) side of the semiconductor package.
